# EUROPÄISCHE PATENTSCHRIFT

(11) **EP 3 376 617 B1**
(45) Veröffentlichungstag und Bekanntmachung des Hinweises auf die Patenterteilung: **09.01.2019**
(21) Anmeldenummer: 17160825.0
(22) Anmeldetag: 14.03.2017
(51) Int. Cl.: H02B 1/052

(54) **BEFESTIGUNGSVORRICHTUNG**
ATTACHMENT DEVICE
DISPOSITIF DE FIXATION

(43) Veröffentlichungstag der Anmeldung: 19.09.2018
(73) Patentinhaber: Sick AG, 79183 Waldkirch (DE)
(72) Erfinder: Saumer, Markus, 77948 Friesenheim (DE); Disch, Alexandra, 79215 Elzach (DE)

(56) Entgegenhaltungen:
- DE-A1- 19 504 762
- US-B1- 7 170 758

## Beschreibung

Die Erfindung betrifft eine Befestigungsvorrichtung zum lösbaren Befestigen eines Gehäuses an einer Befestigungsschiene nach dem Oberbegriff des Anspruchs 1.

Elektronische Geräte mit einem eigenen Gehäuse, das nicht allzu voluminös ausgebildet ist, werden bevorzugt an einer Wand montiert. Hierbei wird das Gehäuse an eine an der Wand vorgesehenen Befestigungsschiene, insbesondere Hut- bzw. Profilschiene, durch eine Befestigungsvorrichtung lösbar befestigt, wobei die Befestigungsvorrichtung beispielsweise Schrauben oder Klemmen umfasst.

Bei einer Schraubenbefestigung werden geeignete Löcher im Gehäuse der elektronischen Geräte und in der Befestigungsschiene sowie Muttern oder geeignete Gewindebohrungen benötigt, so dass das Gehäuse an die Befestigungsschiene verschraubt werden kann. Das Befestigen und Lösen des Gehäuses an die bzw. von der Befestigungsschiene bei der Verwendung der Schraubenbefestigung ist unhandlich und aufwändig. Ferner ist das Herstellen der Schraubenbefestigung, insbesondere Löcher und Gewindebohrung am Gehäuse und/oder an der Befestigungsschiene, ebenfalls aufwändig und damit kostspielig.

Bei einer Klemmenbefestigung werden mehrteilige Konstruktionen verwendet, die beispielsweise Klemmen zum Verriegeln und Entriegeln des Gehäuses von der Befestigungsschiene, Betätigungsmittel zum Betätigen der Klemmen und Federn zum Spannen der Klemmen umfassen. Das Befestigen und Lösen des Gehäuses an die bzw. von der Befestigungsschiene mittels der Klemmenbefestigung ist meistens wenig intuitiv und das Vorsehen der Klemmenbefestigung an das Gehäuse ist aufwändig und kompliziert. Das Montieren der mehrteiligen Konstruktion der Klemmenbefestigung an das Gehäuse ist zeitaufwändig und macht die Konstruktion damit insgesamt teuer.

DE 195 04 762 A1 offenbart eine Entriegelungsvorrichtung, die es ermöglicht, elektrische Klemmen, Module, Installationsgeräte oder dergleichen auf Tragschienen zu montieren. Hierbei umfasst die Entriegelungsvorrichtung einen Spreizbügel mit zwei Bügelenden, der auf einer Rückseite eines Isolierstoffgehäuses angeordnet ist und in die Tragschiene eingreift. Die beiden Bügelenden sind in entgegengesetzte Richtung gerichtet auf der Rückseite des Isolierstoffgehäuses angeordnet und durch einen senkrecht zu den beiden Bügelenden angeordneten Freilauf-Fangkorb miteinander verbunden. In dem Freilauf-Fangkorb greift senkrecht zu den beiden Bügelenden ein Zugstab mittels einer Fangnase ein, so dass durch Ziehen an dem Zugstab in senkrechte Richtung zur Ausrichtung der beiden Bügelenden der Spreizbügel die Rastfüße auseinander drückt, um das Isolierstoffgehäuse von der Tragschiene zu lösen.

US7170758 B1 offenbart eine Verriegelungseinrichtung mit zwei relativ zueinander verschieblichen Verriegelungsschiebern, die über eine Feder miteinander verbunden sind. Es ist daher eine Aufgabe der Erfindung, eine Befestigungsvorrichtung der eingangs genannten Art derart zu verbessern, dass der Hebelmechanismus platzsparend und einfach ausgestaltet werden kann.

Die Aufgabe wird erfindungsgemäß gelöst durch eine Befestigungsvorrichtung mit den Merkmalen des Anspruchs 1.

Gemäß einem bevorzugten Ausführungsbeispiel sind der erste und zweite Haken einander gegenüberliegend im Gehäuse angeordnet. Dies hat den Vorteil, dass die Verriegelungselemente direkt am Gehäuse vorgesehen sind, so dass die Befestigungsvorrichtung an sich weniger Elemente aufweist.

Ferner sind gemäß einem weiteren bevorzugten Ausführungsbeispiel der erste und zweite Hebelarm im Bereich der ersten und zweiten Haken derart nebeneinander angeordnet, dass der erste und zweite Hebelarm in einer gleichen Ebene liegen, wobei der erste Hebelarm den zweiten Hebelarm umgibt oder vice versa. Hierdurch ist eine kompakte Ausbildung der Befestigungsvorrichtung erreichbar.

Vorteilhafterweise sind der erste und zweite Hebelarm in entgegengesetzte Richtung koaxial bewegbar, wenn das Betätigungsmittel getätigt ist. Dadurch ergibt sich der Vorteil, dass beide Haken bei einer Betätigung des Betätigungsmittels synchron und koaxial in entgegengesetzte Richtungen bewegt werden. Das heißt mit anderen Worten, beide Haken werden gleichzeitig in eine geöffnete oder in eine geschlossene Stellung bewegt, so dass die Befestigung des Gehäuses an die Befestigungsschiene intuitiv erfolgen kann. Ferner hat das Bewegen der beiden Haken in entgegengesetzte koaxiale Richtungen den Vorteil, dass das Gehäuse ohne eine Kippung an die bzw. von der Befestigungsschiene montiert werden kann, wenn beide Haken mit einer Betätigung des Betätigungsmittels in die geöffnete Stellung bewegt werden.

Gemäß einem weiteren bevorzugten Ausführungsbeispiel weist der erste und zweite Hebelarm jeweils eine Nut auf, die formschlüssig zu einem Ende des jeweiligen Hakens ausgebildet ist. Mit anderen Worten, die Haken sind auf einer Seite mit dem Gehäuse verbunden und weisen auf der anderen Seite jeweils ein bewegbares Ende auf, das formschlüssig zu der jeweiligen Nut des ersten bzw. zweiten Hebelarms ausgebildet ist, so dass die Hebelarme formschlüssig auf die Enden der Haken aufsteckbar sind. Dies ermöglicht eine einfache Montage des Hebelmechanismus an dem Gehäuse. Vorteilhafterweise ist der Hebelmechanismus teilweise aus einem flexiblen Material gefertigt. Hierdurch ist die Herstellung des Hebelmechanismus einfach und preisgünstig.

Gemäß einem weiteren bevorzugten Ausführungsbeispiel ist der Hebelmechanismus im Bereich des Lagerabschnitts flexibel und im Bereich der Haken unflexibel ausgebildet, so dass eine genaue Verriegelung bzw. Entriegelung des Gehäuses möglich ist.

Weiterhin sind gemäß einem bevorzugten Ausführungsbeispiel der erste und zweite Hebelarm im Bereich der jeweiligen Haken dickwandig und im Bereich des Lagerabschnitts dünnwandig ausgebildet. Vorzugsweise ist der Hebelmechanismus formschlüssig in einer im Gehäuse vorgesehenen Form angeordnet. Hierdurch ist eine Anbringung der Befestigungsvorrichtung an dem Gehäuse einfach durchführbar.

Ferner ist es eine Aufgabe der Erfindung eine, insbesondere modulare, Sicherheitssteuerung zur Verfügung zu stellen, die einfach an eine Befestigungsschiene lösbar montiert werden kann.

Die Aufgabe wird erfindungsgemäß gelöst durch eine Sicherheitssteuerung mit einer Befestigungsvorrichtung gemäß dem Anspruch 1.

Bevorzugte Ausgestaltungen und Weiterbildungen sowie weitere Vorteile der Erfindung sind den Unteransprüchen, der nachfolgenden Beschreibung und den Zeichnungen zu entnehmen.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Fig. 1: eine schematische perspektive Teildarstellung eines Gehäuses mit darin enthaltener erfindungsgemäßen Befestigungsvorrichtung,
- Fig. 2: eine perspektive Detaildarstellung der erfindungsgemäßen Befestigungsvorrichtung, und
- Fig. 3: eine seitliche Detaildarstellung der erfindungsgemäßen Befestigungsvorrichtung im im Gehäuse montierten Zustand.

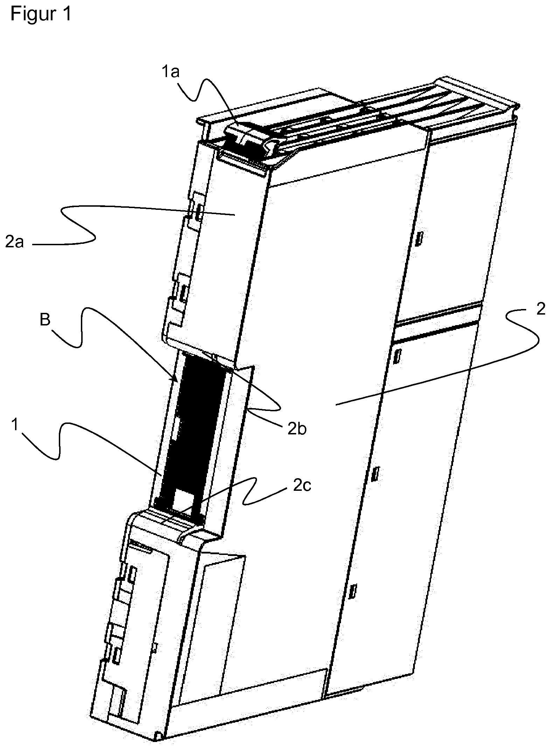

Die Figur 1 zeigt eine schematische perspektive Teildarstellung einer erfindungsgemäßen Befestigungsvorrichtung B im montierten Zustand in einer Rückwand 2a eines Gehäuses 2. Hierbei umhaust das Gehäuse 2 in dem Ausführungsbeispiel ein Modul einer modularen Sicherheitssteuerung. Mehrere solche Gehäuse 2 von Modulen der modularen Sicherheitssteuerung können nebeneinander angeordnet werden, wobei die Module seitlich elektrisch miteinander verbindbar sind.

Die Rückwand 2a des Gehäuses 2 ist mittels der Befestigungsvorrichtung B an einer nicht dargestellten Befestigungsschiene montierbar, wobei die Befestigungsschiene vorzugsweise eine Hutschiene oder eine Profilschiene umfasst. Hierbei ist die Befestigungsschiene in einem freien Absatz 3 an der Rückwand 2a des Gehäuses 2 anordenbar, wobei die Befestigungsvorrichtung B entlang des freien Absatzes 3 verläuft.

Die Befestigungsvorrichtung B umfasst einen einteiligen Hebelmechanismus 1 zum Verriegeln und Entriegeln des Gehäuses 2 mit bzw. von der Befestigungsschiene. Der Hebelmechanismus 1 weist ein Betätigungsmittel 1a auf, das den Hebelmechanismus 1 in eine verriegelnde Stellung V oder in eine entriegelnde Stellung E bewegt. In der verriegelnden Stellung V verriegelt der Hebelmechanismus 1 das Gehäuse 2 an die Befestigungsschiene. In der entriegelnden Stellung E entriegelt der Hebelmechanismus 1 das Gehäuse 2 von der Befestigungsschiene, so dass das Gehäuse 2 von der Befestigungsschiene lösbar und entfernbar ist.

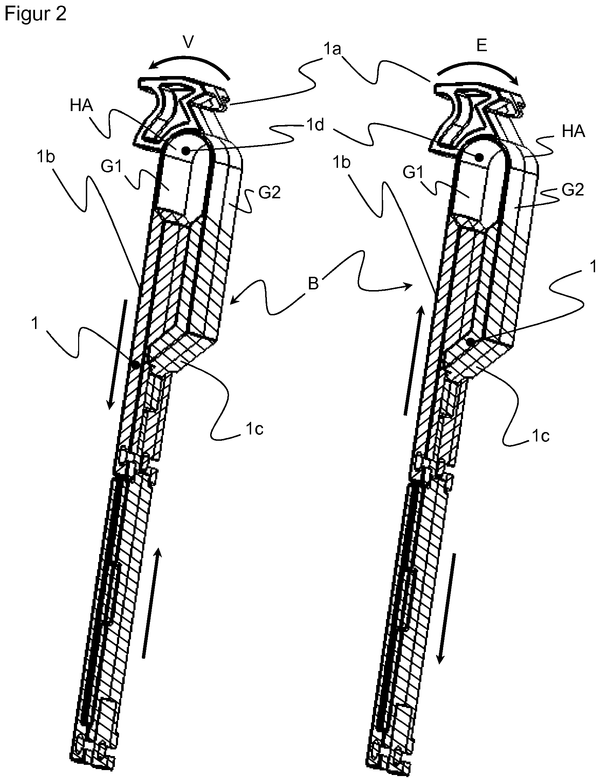

Hierfür weist der Hebelmechanismus 1, wie in einer perspektiven Detaildarstellung der erfindungsgemäßen Befestigungsvorrichtung B in der Figur 2 dargestellt, einen ersten Hebelarm 1b und einen zweiten Hebelarm 1c auf. Hierbei sind der erste und zweite Hebelarm 1b und 1c miteinander über das Betätigungsmittel 1a derart verbunden, so dass bei einer Betätigung des Betätigungsmittels 1a in eine Richtung der erste Hebelarm 1b in eine erste Richtung und der zweite Hebelarm 1c in eine zweite Richtung bewegt werden, wobei die erste und zweite Richtung der ersten und zweiten Hebelarme 1b und 1c entgegengesetzt zueinander sind.

Mit anderen Worten, wird das Betätigungsmittel 1a in die verriegelnde Stellung V bewegt, betätigt der erste Hebelarm 1b bei seiner Bewegung einen im Gehäuse 2 vorgesehenen, in der Figur 1 dargestellten ersten Haken 2b in die erste Richtung. Gleichzeitig betätigt der zweite Hebelarm 1c bei seiner Bewegung einen im Gehäuse 2 vorgesehenen, in der Figur 1 dargestellten zweiten Haken 2c in die zweite Richtung. Der erste und zweite Haken 2b und 2c verriegeln in dieser verriegelnden Stellung V das Gehäuse 2 an die Befestigungsschiene, wobei der erste und zweite Haken 2b und 2c insbesondere einander gegenüberliegend im Gehäuse 2 angeordnet sind. Das heißt, bezogen auf eine Bewegungsrichtung der ersten und zweiten Hebelarme 1b und 1c sind der erste und zweite Haken 2b und 2c entlang der Bewegungsrichtung angeordnet.

Wird das Betätigungsmittel 1a in die entriegelnde Stellung E bewegt, betätigt der erste Hebelarm 1b bei seiner Bewegung den ersten Haken 2b in eine der ersten Richtung entgegengesetzte Richtung. Gleichzeitig betätigt der zweite Hebelarm 1c bei seiner Bewegung den zweiten Haken 2c in eine der zweiten Richtung entgegengesetzte Richtung. Hierdurch entriegeln der erste und zweite Haken 2b und 2c in dieser entriegelnden Stellung E das Gehäuse 2 von der Befestigungsschiene.

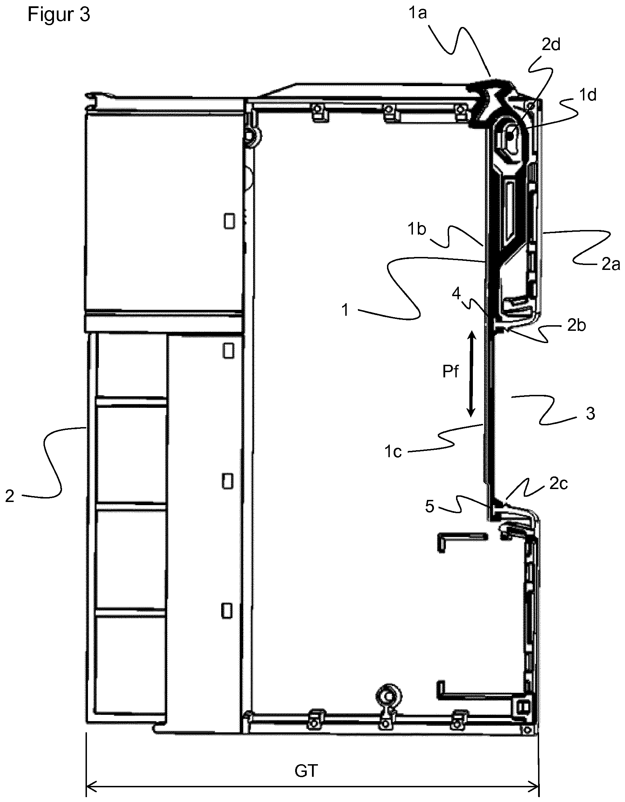

Dadurch, dass der erste und zweite Haken 2b und 2c synchron und koaxial in die entriegelnde Stellung E bewegt werden, kann das Gehäuse 2 vorteilhafterweise ohne eine Kippung senkrecht zu der Befestigungsschiene entfernt werden. Diese vereinfachte Handhabung wird besonders ersichtlich, wenn beispielsweise mehrere Gehäuse nebeneinander auf einer Befestigungsschiene und übereinander auf mehreren parallel übereinander angeordneten Befestigungsschienen angeordneten sind, so dass kein Platz für ein Kippen des Gehäuses 2 vorhanden ist. Vor allem, wenn das Gehäuse 2, wie in der Figur 3 gezeigt, eine Gehäusetiefe GT aufweist, ist ein gerades Entfernen des Gehäuses 2 von der Befestigungsschiene vorteilhaft und bei übereinander angeordneten Befestigungsschienen erforderlich.

Weiterhin sind der erste und zweite Hebelarm 1b und 1c über das Betätigungsmittel 1a derart miteinander verbunden, dass ein Lagerabschnitt 1d gebildet ist. Der Lagerabschnitt 1d weist eine parabelähnliche Form mit zwei parallelen Schenkeln auf. Das heißt, die parabelähnliche Form weist einen Halbkreisabschnitt HA, mit dem das Betätigungsmittel 1a verbunden ist, und zwei parallel verlaufende und sich an dem Halbkreisabschnitt HA anschließende gerade Schenkelabschnitte G1 und G2 auf, die die Schenkel bilden, so dass der Halbkreisabschnitt HA und die beiden parallel verlaufenden geraden Schenkelabschnitte G1 und G2 zusammen den Lagerabschnitt 1d bilden.

Der erste und zweite Hebelarm 1b und 1c schließt sich jeweils direkt an die jeweiligen parallel verlaufenden geraden Schenkelabschnitte G1 und G2 an. Hierbei sind der erste und zweite Hebelarm 1b und 1c im Bereich der ersten und zweiten Haken 2b und 2c vorzugsweise derart nebeneinander angeordnet, dass der erste und zweite Hebelarm 1b und 1c in einer gleichen Ebene liegen, so dass eine schlanke Kontur des Hebelmechanismus 1 ermöglicht ist.

Der erste Hebelarm 1b weist zwei Teil-Arme auf, die den zweiten Hebelarm 1c umgeben, so dass sich der zweite Hebelarm 1c zwischen den beiden Teil-Armen des ersten Hebelarms 1b und relativ zu dem ersten Hebelarm 1b bewegt, wenn der Hebelmechanismus 1 betätigt wird. Entgegen der Darstellung in der Figur 3, kann die Ausgestaltung der beiden Hebelarme 1b und 1c auch vice versa ausgeführt sein. Das heißt, der zweite Hebelarm 1c weist zwei Teil-Arme auf und der erste Hebelarm 1b ist zwischen den beiden Teil-Arme des zweiten Hebelarms 1c angeordnet.

Wie in der Figur 3 dargestellt, ist der Hebelmechanismus 1 formschlüssig in Bezug auf eine Ebene, die parallel zu der Gehäusetiefe GT des Gehäuses 2 verläuft, in einer im Gehäuse 2 vorgesehenen Form angeordnet, wobei der Lagerabschnitt 1d einen Absatz 2d des Gehäuses 2 umschließt. Hierdurch ist eine Bewegung des Hebelmechanismus 1 in eine Richtung, die koaxial zu der Gehäusetiefe GT des Gehäuses 2 verläuft, verhindert. Eine Bewegung des Hebelmechanismus 1 in der Form und senkrecht zu der Gehäusetiefe GT des Gehäuses 2 entlang eines in der Figur 3 dargestellten Pfeils Pf ist möglich, um den ersten und zweiten Hebelarm 1b und 1c in die verriegelnde Stellung V bzw. in die entriegelnde Stellung E zu bewegen, so dass eine geführte Bewegung des Hebelmechanismus 1 ermöglicht ist.

Bei der Betätigung des Hebelmechanismus 1 in die verriegelnde bzw. entriegelnde Stellung V bzw. E verformt sich die parabelförmige Form des Lagerabschnittes 1d, so dass sich der Lagerabschnitt 1d entlang des Absatzes 2d in Richtung der Betätigung rotierend gleitet und damit die beiden geraden Schenkelabschnitte G1 und G2 in entgegengesetzte Richtungen sich bewegen. Die beiden Hebelarme 1b und 1c des Hebelmechanismus 1 können sich entlang des dargestellten Pfeils Pf nach oben bzw. nach unten in Bezug auf die dargestellte Seitenlage des Gehäuses 2 bewegen.

Der erste Hebelarm 1b weist an einem Ende eine Nut 4 zur formschlüssigen Aufnahme eines Endes des ersten Hakens 2b auf. Der zweite Hebelarm 1c weist an seinem freien Ende ebenfalls eine Nut 5 zur formschlüssigen Aufnahme eines Endes des zweiten Hakens 2c auf. Sobald die Hebelarme 1b und 1c durch Betätigen des Betätigungsmittels 1a in die erste bzw. zweite Richtung oder auch umgekehrt bewegt werden, werden die mittels der in den Nuten 4 und 5 aufgenommenen Enden entsprechend gehaltenen ersten und zweiten Haken 2b und 2c mitbewegt, um das Gehäuse 2 zu verriegeln oder zu entriegeln.

Der Hebelmechanismus 1 ist teilweise aus einem flexiblen Material und durch einen Spritzprozess gefertigt. Hierbei ist der Lagerabschnitt 1d und insbesondere dessen zwei parallelen Schenkel bzw. die zwei parallel verlaufenden geraden Schenkelabschnitte G1 und G2 der parabelähnlichen Form dünnwandig ausgebildet, wodurch der Hebelmechanismus 1, insbesondere im Bereich des Lagerabschnitts 1d, flexibel und damit leicht beweglich ausgebildet ist.

Im Bereich des ersten und zweiten Hakens 2b und 2c des Gehäuses 2 ist der Hebelmechanismus 1, insbesondere der erste und zweite Hebelarm 1b und 1c, dickwandig und somit unflexibel bzw. starrer als der Lagerabschnitt 1d ausgebildet. Hierdurch ist sichergestellt, dass der erste und zweite Hebelarm 1b und 1c den ersten und zweiten Haken 2b und 2c kraftschlüssig und spielfrei entsprechend der Betätigung des Betätigungsmittels 1a in die jeweilige verriegelnde bzw. entriegelnde Stellung V bzw. E bewegen.

Nach der Herstellung des Hebelmechanismus 1 wird der Hebelmechanismus 1 in die im Gehäuse 2 vorgesehene Form, wie in der Figur 3 gezeigt, aufgesteckt, so dass die Nuten 4 und 5 die jeweiligen Enden des ersten und zweiten Hakens 2b und 2c umgreifen und der Lagerabschnitt 1d den Absatz 2d des Gehäuses 2 umschließt.

Mit Aufsetzen einer nicht dargestellten Seitenwand des Gehäuses 2 ist der Hebelmechanismus 1 umschlossen und die erfindungsgemäße Befestigungsvorrichtung B ausgebildet. Die Seitenwand verhindert ein Lösen der Befestigungsvorrichtung B aus der vorgesehenen Form des Gehäuses 2. Die Montage der Befestigungsvorrichtung B ist einfach handhabbar und die Bedienung des Hebelmechanismus 1 ist intuitiv.

### Bezugszeichenliste

- B: Befestigungsvorrichtung
- 1: Hebelmechanismus
- 1a: Betätigungsmittel
- 1b, 1c: Erster und zweiter Hebelarm
- 1d: Lagerabschnitt
- 2: Gehäuse
- 2a: Rückwand
- 2b und 2c: Erster und zweiter Haken
- 2d: Absatz
- 3: Freier Absatz
- 4, 5: Nut
- E: Entriegelnde Stellung
- G1, G2: Parallel verlaufende Gerade
- GT: Gehäusetiefe des Gehäuses 2
- HA: Halbkreisabschnitt
- Pf: Pfeil
- V: Verriegelnde Stellung

## Patentansprüche

1. Befestigungsvorrichtung (B) zum lösbaren Befestigen eines Gehäuses (2) an einer Befestigungsschiene, mit einem Hebelmechanismus (1) zum Verriegeln und Entriegeln des Gehäuses (2) mit bzw. von der Befestigungsschiene,
wobei der Hebelmechanismus (1) ein Betätigungsmittel (1a), das den Hebelmechanismus (1) in eine verriegelnde Stellung (V) oder in eine entriegelnde Stellung (E) bewegt, einen ersten Hebelarm (1b), der einen im Gehäuse (2) vorgesehenen ersten Haken (2b) in eine erste Richtung betätigt, und einen zweiten Hebelarm (1c), der einen im Gehäuse (2) vorgesehenen zweiten Haken (2c) in eine zweite Richtung betätigt, umfasst, wobei die erste und zweite Richtung entgegengesetzt zueinander sind, **dadurch gekennzeichnet dass** der Hebelmechanismus (1) einteilig ist und der erste und zweite Hebelarm (1b, 1c) über das Betätigungsmittel (1a) derart miteinander verbunden sind, dass ein Lagerabschnitt (1d) gebildet ist, der eine parabelähnliche Form mit zwei parallelen Schenkeln aufweist, wobei jeder Schenkel einen geraden Schenkelabschnitt (G1, G2) umfasst und der erste und zweite Hebelarm (1b, 1c) sich jeweils direkt an die jeweiligen parallel verlaufenden geraden Schenkelabschnitte (G1, G2) anschließt, so dass die Schenkelabschnitte (G1, G2) und der erste und zweite anschließende Hebelarm (1b, 1c) koaxial bewegbar sind.

2. Befestigungsvorrichtung (B) nach Anspruch 1, **dadurch gekennzeichnet, dass** der erste und zweite Haken (2b, 2c) einander gegenüberliegend im Gehäuse (2) angeordnet sind.

3. Befestigungsvorrichtung (B) nach Anspruch 1 oder 2, **dadurch gekennzeichnet, dass** der erste und zweite Hebelarm (1b, 1c) im Bereich der ersten und zweiten Haken (2b, 2c) derart nebeneinander angeordnet sind, dass der erste und zweite Hebelarm (1b, 1c) in einer gleichen Ebene liegen, wobei der erste Hebelarm (1b) den zweiten Hebelarm (1c) umgibt oder vice versa.

4. Befestigungsvorrichtung (B) nach einem der vorhergehenden Ansprüche, **dadurch gekennzeichnet, dass** der erste und zweite Hebelarm (1b, 1c) in entgegengesetzte Richtung koaxial bewegbar sind, wenn das Betätigungsmittel (1a) betätigt wird.

5. Befestigungsvorrichtung (B) nach einem der vorhergehenden Ansprüche, **dadurch gekennzeichnet, dass** der erste und zweite Hebelarm (1b, 1c) jeweils eine Nut (4, 5) aufweist, die formschlüssig zu einem Ende des jeweiligen Hakens (2b, 2c) ausgebildet ist.

6. Befestigungsvorrichtung (B) nach einem der vorhergehenden Ansprüche, **dadurch gekennzeichnet, dass** der Hebelmechanismus (1) teilweise aus einem flexiblen Material gefertigt ist.

7. Befestigungsvorrichtung (B) nach Anspruch 6, **dadurch gekennzeichnet, dass** der Hebelmechanismus (1) im Bereich des Lagerabschnitts (1d) flexibel und im Bereich der ersten und zweiten Haken (2b, 2c) unflexibel ausgebildet ist.

8. Befestigungsvorrichtung (B) nach einem der vorhergehenden Ansprüche, **dadurch gekennzeichnet, dass** der erste und zweite Hebelarm (1b, 1c) im Bereich der jeweiligen ersten und zweiten Haken (2b, 2c) dickwandig ausgebildet sind und der Lagerabschnitt (1d) dünnwandig ausgebildet ist.

9. Befestigungsvorrichtung (B) nach einem der vorhergehenden Ansprüche, **dadurch gekennzeichnet, dass** der Hebelmechanismus (1) formschlüssig in Bezug auf eine Ebene, die parallel zu einer Gehäusetiefe (GT) des Gehäuses (2) verläuft, in einer im Gehäuse (2) vorgesehenen Form angeordnet ist.

10. Sicherheitssteuerung mit einer Befestigungsvorrichtung (B) nach einem der vorhergehenden Ansprüche 1 bis 9.

## Claims

1. Fastening apparatus (B) for the releasable fastening of a housing (2) to a fastening rail, having a lever mechanism (1) for latching and unlatching the housing (2) to and from the fastening rail, wherein the lever mechanism (1) comprises an actuation means (1a) that moves the lever mechanism (1) into one of a latching position (V) and an unlatching position (E); a first lever arm (1b) that actuates a first hook (2b) provided in the housing (2) in a first direction; and a second lever arm (1c) that actuates a second hook (2c) provided in the housing (2) in a second direction, and wherein the first and second directions are opposite one another **characterized in that** the lever mechanism (1) is a single-part mechanism and the first and second lever arms (1b, 1c) are connected to one another via the actuation means (1a) such that a support section (1d) is formed that has a parabola-like form having two parallel limbs, wherein each limb has a straight limb section (G1, G2) and the first and second lever arms (1b, 1c) are directly connected to the straight parallel limb sections (G1, G2), respectively, so that the limb sections (G1, G2) and the first and second connected lever arms (1, 1c) are coaxially movable.

2. Fastening apparatus (B) in accordance with claim 1, **characterized in that** the first and second hooks (2b, 2c) are arranged opposite one another in the housing (2).

3. Fastening apparatus (B) in accordance with claim 1 or 2, **characterized in that** the first and second lever arms (1b, 1c) are arranged next to one another in the region of the first and second hooks (2b, 2c) such that the first and second lever arms (1b, 1c) are in the same plane, with the first lever arm (1b) surrounding the second lever arm (1c) or vice versa.

4. Fastening apparatus (B) in accordance with any preceding claim, **characterized in that** the first and second lever arms (1b, 1c) are coaxially movable in opposite directions when the actuation means (1a) is actuated.

5. Fastening apparatus (B) in accordance with any preceding claim, **characterized in that** the first and second lever arms (1b, 1c) each have a groove (4, 5) that is formed with shape matching with respect to an end of the respective hook (2b, 2c).

6. Fastening apparatus in accordance with any preceding claim, **characterized in that** the lever mechanism (1) is partly produced from a flexible material.

7. Fastening apparatus in accordance with claim 6, **characterized in that** the lever mechanism (1) is flexible in the region of the support section (1d) and inflexible in the region of the first and second hooks (2b, 2c).

8. Fastening apparatus in accordance with any preceding claim, **characterized in that** the first and second lever arms (1b, 1c) are thick-walled in the region of the respective first and second hooks (2b, 2c) and the support section (1d) is thin-walled.

9. Fastening apparatus in accordance with any preceding claim, **characterized in that** the lever mechanism (1) is arranged with shape matching in a form provided in the housing (2) with respect to a plane that extends in parallel with a housing depth (GT) of the housing (2).

10. A safety control having a fastening apparatus (B) in accordance with any of the preceding claims 1 to 9.

## Revendications

1. Dispositif de fixation (B) pour la fixation amovible d'un boîtier (2) sur un rail de fixation, comprenant un mécanisme à levier (1) pour verrouiller et déverrouiller le boîtier (2) sur le rail de fixation et le déverrouiller, le mécanisme à levier (1) comprenant un moyen d'actionnement (1a) qui déplace le mécanisme à levier (1) dans une position de verrou (V) et une position déverrouillée (E) ; un premier levier (1b) qui active un premier crochet (2b) prévu dans le boîtier (2) dans une première direction ; et un deuxième bras de levier (1c) qui actionne un deuxième crochet (2c) prévu dans le boîtier (2) dans une deuxième direction, et dans lequel les première et deuxième directions sont opposées l'une à l'autre, **caractérisé en ce que** le mécanisme de levier (1) est un mécanisme monobloc et les premier et deuxième bras de levier (1b, 1c) sont reliés entre eux via le moyen de commande (1a) de manière à former une partie de support (1d) qui présente une forme analogue à une parabole ayant deux bras parallèles, dans laquelle chaque branche a une section de branche droite (G1, G2) et les premier et second bras de levier (1b, 1c) sont directement reliés aux sections de branche parallèles droites (G1, G2), respectivement, de sorte que les sections de branche (G1, G2) et les premier et second bras de levier reliés (1, 1c) soient mobiles coaxialement.

2. Dispositif de fixation (B) selon la revendication 1, **caractérisé en ce que** les premier et deuxième crochets (2b, 2c) sont disposés dans le boîtier (2) en vis-à-vis.

3. Dispositif de fixation (B) selon la revendication 1 ou 2, **caractérisé en ce que** les premier et second bras de levier (1b, 1c) sont disposés l'un à côté de l'autre dans la zone des premier et second crochets (2b, 2c) de sorte que les premier et second bras de levier (1b, 1c) sont dans le même plan, le premier bras de levier (1b) entourant le second bras de levier (1c) et vice versa.

4. Dispositif de fixation (B) selon n'importe quelle revendication précédente, **caractérisé en ce que** les premier et second bras de levier (1b, 1c) sont mobiles coaxialement dans des directions opposées lorsque le moyen de commande (1a) est actionné.

5. Dispositif de fixation (B) selon n'importe quelle revendication précédente, **caractérisé en ce que** les premier et second bras de levier (1b, 1c) ont chacun une rainure (4, 5) qui est formée avec une forme adaptée par rapport à une extrémité du crochet respectif (2b, 2c).

6. Dispositif de fixation selon n'importe quelle revendication précédente, **caractérisé en ce que** le mécanisme à levier (1) est fabriqué en partie à partir d'un matériau flexible.

7. Dispositif de fixation selon la revendication 6, **caractérisé en ce que** le mécanisme à levier (1) est flexible dans la zone de la section de support (1d) et rigide dans la zone des premier et second crochets (2b, 2c).

8. Dispositif de fixation selon toute revendication précédente, **caractérisé en ce que** les premier et second bras de levier (1b, 1c) sont à paroi épaisse dans la zone des premier et second crochets respectifs (2b, 2c) et la section de support (1d) est à paroi mince.

9. Dispositif de fixation selon l'une quelconque des revendications précédentes, **caractérisé en ce que** le mécanisme à levier (1) est agencé avec une forme adaptée à la forme prévue dans le boîtier (2) par rapport à un plan qui s'étend parallèlement à une profondeur de boîtier (GT) du boîtier (2).

10. Commande de sécurité ayant un appareil de fixation (B) selon l'une quelconque des revendications précédentes 1 à 9.
